# FASCICULE DE BREVET EUROPEEN

(11) **EP 1 710 913 B1**
(45) Date de publication et mention de la délivrance du brevet: **21.04.2010**
(21) Numéro de dépôt: 06290271.3
(22) Date de dépôt: 16.02.2006
(51) Int. Cl.: H03K 17/16, H02M 1/00

(54) **Source d'alimentation à découpage**
Getakte Stromversorgung
Switching power supply

(30) Priorité: 04.03.2005 FR 0502222
(43) Date de publication de la demande: 11.10.2006
(73) Titulaire: STMicroelectronics SA, 92120 Montrouge (FR)
(72) Inventeur: Balmefrezol, Alexandre, 38360 Sassenage (FR); Patry, Jean-Luc, 38920 Crolles (FR)
(74) Mandataire: Bentz, Jean-Paul

(56) Documents cités:
- FR-A- 2 841 061
- US-A1- 2004 070 377
- US-A1- 2004 207 372

## Description

L'invention concerne de façon générale les sources d'alimentation à découpage et en particulier des sources d'alimentation à découpage présentant une inductance dont le niveau de tension est défini par deux commutateurs de commande.

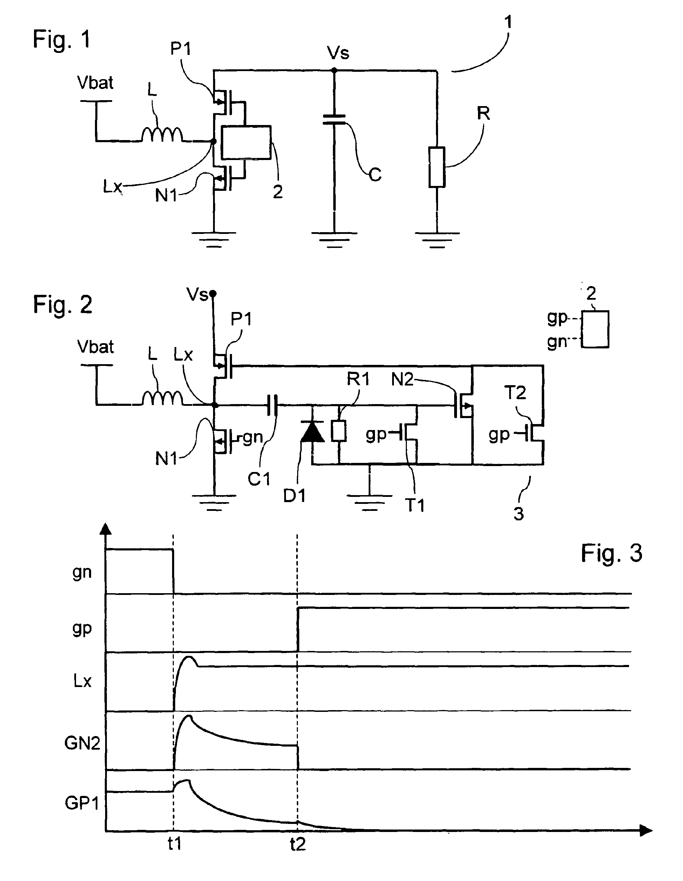

La figure 1 illustre une source d'alimentation à découpage 1 de l'état de la technique. Cette alimentation à découpage 1 est un convertisseur continu-continu élévateur de tension tel que décrit dans le document FR-2 841 061. La source d'alimentation à découpage 1 présente une inductance L connectée d'une part à une source d'alimentation à courant continu Vbat et d'autre part à un noeud intermédiaire Lx. Un transistor NMos N1 a sa source connectée à la masse et son drain connecté au noeud Lx. Un transistor PMos P1 a son drain connecté au noeud Lx et sa source connectée à la sortie Vs de l'alimentation à découpage 1. Une charge R à alimenter et un condensateur C sont connectés en parallèle entre la sortie Vs et la masse. Un dispositif de commande d'alimentation à découpage 2 est connecté aux grilles des transistors P1 et N1. Le dispositif de commande 2 pilote les transistors P1 et N1 de façon que l'un soit bloqué lorsque l'autre est passant et de façon à éviter que le courant circulant à travers l'inductance devienne négatif. Afin d'éviter que les transistors P1 et N1 soient passants simultanément, lors du blocage d'un transistor, l'autre transistor est maintenu bloquée pendant une durée généralement comprise entre 20 et 100 ns avant d'être rendu passant.

Durant la phase transitoire où les deux transistors sont bloqués, de l'énergie stockée dans l'inductance est évacuée dans le substrat par l'intermédiaire du transistor PNP parasite intrinsèquement formé par le transistor P1 en technologie CMOS. Cette évacuation de courant dans le substrat grève le rendement énergétique de l'alimentation à découpage. De plus, ce courant peut perturber le fonctionnement d'autres dispositifs intégrés dans le substrat. En outre, lorsque le transistor PNP parasite formé par P1 est conducteur, le noeud intermédiaire Lx subit une surtension qui peut nuire à la fiabilité du transistor N1.

L'invention vise à résoudre un ou plusieurs de ces inconvénients. L'invention porte ainsi sur une source d'alimentation à découpage comprenant :
- une inductance présentant des première et seconde bornes ;
- un noeud de sortie;
- un transistor NMos dont la source est connectée à la masse et dont le drain est connecté à la première électrode de l'inductance ;
- un transistor PMos dont le drain est connecté à la première électrode de l'inductance ;
- un dispositif de commande d'alimentation à découpage générant des signaux de commande de commutation des transistors NMos et PMos aptes à ne pas rendre ces transistors passants simultanément;
- une capacité présentant une première borne connectée à la première borne de l'inductance et une seconde borne ;
- une résistance présentant une première borne connectée à la seconde borne de la capacité et une seconde borne connectée à la masse ;
- un transistor NMos de détection, dont la source est connectée à la masse, dont le drain est connecté à la grille du transistor PMos et dont la grille est connectée à la seconde borne de la capacité.

Selon une variante:
- la seconde borne de l'inductance est connectée à une source d'alimentation à courant continu ;
- la source du transistor PMos est connectée au noeud de sortie.

Selon encore une variante, au moins un autre noeud de sortie et au moins un autre transistor PMos dont le drain est connecté à la première électrode de l'inductance, dont la source est connectée à l'autre noeud de sortie et dont la grille est connectée au drain du transistor NMos de détection.

Selon encore une autre variante, la source d'alimentation à découpage comprend en outre un transistor de blocage présentant une première électrode connectée à la masse, une seconde électrode connectée à la grille du transistor NMos de détection et une électrode de commande ; le dispositif de commande d'alimentation à découpage rendant passant le transistor de blocage lorsque le transistor NMos de détection est passant.

Selon une autre variante, la source d'alimentation à découpage comprend en outre un transistor de commande, présentant une première électrode connectée à la masse, une seconde électrode connectée à la grille du transistor PMos et une électrode de commande ; le dispositif de commande d'alimentation à découpage commandant une conduction simultanée du transistor de commande et du transistor de blocage.

Lesdits transistors, la capacité et la résistance peuvent être intégrés sur un même substrat.

D'autres caractéristiques et avantages de l'invention ressortiront clairement de la description qui en est faite ci-après, à titre indicatif et nullement limitatif, en référence aux dessins annexés, dans lesquels :
- la figure 1 illustre une alimentation à découpage éleveur de tension selon l'art antérieur ;
- la figure 2 illustre un exemple d'alimentation à découpage éleveur de tension selon l'invention ;
- la figure 3 est un chronogramme représentant le fonctionnement de l'alimentation à découpage pour rendre passant son transistor PMos.

L'invention propose de détecter une commutation de blocage du transistor NMos et de rendre passant le transistor PMos lors de cette détection. En effet, le blocage du transistor NMos créé une surtension au niveau des drains des transistors PMos et NMos. Un circuit RC connecté aux drains des transistors PMos et NMos rend passant un transistor de détection NMos lors de l'apparition de la surtension. Lorsque le transistor de détection est passant, le transistor PMos est également rendu passant.

L'invention permet de garantir une mise en conduction du transistor PMos dès que le blocage du transistor NMos est détecté. La durée de blocage simultané du transistor NMos et du transistor PMos est ainsi particulièrement réduite. La durée de conduction dans le substrat par l'intermédiaire du transistor parasite est par conséquent également réduite, ce qui accroît le rendement de l'alimentation à découpage et limite d'éventuelles perturbations sur d'autres circuits intégrés. Ces résultats sont en outre obtenus sans faire appel à un circuit comparateur à temps de réponse réduit, qui accroîtrait le coût et les difficultés d'intégration de l'alimentation à découpage.

La figure 2 représente une source d'alimentation à découpage 3 formant un convertisseur continu-continu élévateur de tension. Une inductance L présente une première électrode connectée à un noeud intermédiaire Lx et une seconde électrode connectée à une source d'alimentation à courant continu Vbat. Un transistor NMos N1 a sa source connectée à la masse et son drain connecté au noeud intermédiaire Lx. Un transistor PMos P1 a sa source connectée à un noeud de sortie Vs et son drain connecté au noeud intermédiaire Lx. Un condensateur C1 a sa première borne connectée au noeud intermédiaire Lx et sa seconde borne connectée à la grille d'un transistor NMos N2. La source du transistor N2 est connectée à la masse et son drain est connecté à la grille du transistor P1. Une diode D1, une résistance R1 et un transistor T1 sont connectés en parallèle entre la grille du transistor N2 et la masse. Un transistor T2 présente une première électrode connectée à la masse et une seconde électrode connectée à la grille du transistor P1. Un dispositif de commande d'alimentation à découpage 2 génère des signaux de commande gp et gn. Ces signaux de commande sont prévus pour commander les commutations des transistors N1 et P1, afin de définir le niveau de tension sur le noeud de sortie Vs, tout en évitant que les transistors N1 et P1 soient passants simultanément. Le signal gn est appliqué sur la grille du transistor N1 et le signal gp est appliqué sur les électrodes de commande des transistors T1 et T2.

Le fonctionnement de l'alimentation à découpage 3 lors du blocage du transistor N1 est illustré à la figure 3.

Avant l'instant t1, le transistor N1 est passant, sa grille étant polarisée par le signal gn au niveau haut. Le signal gp est au niveau bas et ainsi les transistors T1 et T2 sont bloqués. Le transistor N2 est bloqué par le niveau bas appliqué sur sa grille (signal GN2). Le transistor P1 est bloqué par le niveau haut appliqué sur sa grille (signal GP1).

A l'instant t1, le dispositif de commande 2 génère un front descendant du signal gn, bloquant le transistor N1. Une surtension est alors générée sur le noeud intermédiaire Lx. Un courant traverse alors le condensateur C1 et la résistance R1. La tension GN2 s'élève alors et rend le transistor N2 passant. La tension Gp1 chute alors et le transistor P1 devient passant. Ainsi, une surtension sur le noeud intermédiaire Lx rend le transistor P1 passant.

Afin de rapidement bloquer le transistor N2 tout en maintenant le transistor P1 passant, un front montant du signal gp est généré à l'instant t2. Les transistors T1 et T2 sont ainsi rendus passants. La grille de N2 est alors connectée à la masse et le transistor N2 se bloque. Le transistor T2 passant maintient le transistor P1 passant.

Les inventeurs ont déterminé que l'invention permettait d'obtenir une durée séparant le blocage de N1 et la mise en conduction de P1 inférieure à 5ns. Pendant la durée séparant la mise en conduction de P1 et l'instant t2, la puissance dissipée dans le transistor N2 est nettement inférieure à la puissance dissipée dans le substrat dans l'art antérieur. Le rendement de l'alimentation à découpage est ainsi amélioré.

L'invention est particulièrement adaptée pour une source d'alimentation à découpage présentant plusieurs sorties. On peut ainsi prévoir que le convertisseur élévateur de tension illustré précédemment présente plusieurs noeuds de sortie. Chaque noeud de sortie est connecté à la source d'un transistor PMos respectif, le drain de ce transistor étant connecté au noeud intermédiaire Lx. Le drain du transistor N2 est connecté à la grille de chaque transistor PMos. Une surintensité sur le noeud intermédiaire Lx permet ainsi de rendre passant l'ensemble des transistors PMos associés aux noeuds de sortie.

L'homme du métier peut constater que la solution de l'invention peut être mise en oeuvre avec des composants usuels, qui peuvent facilement être intégrés dans le même substrat que les transistors de l'alimentation à découpage.

Bien que l'exemple décrit traite uniquement d'un convertisseur élévateur de tension, l'homme du métier parviendra aisément à former un convertisseur abaisseur de tension sur la base de l'enseignement précédent.

## Revendications

1. Source d'alimentation à découpage (3), comprenant :
- une inductance (L) présentant des première et seconde bornes ;
- un noeud de sortie (Vs) ;
- un transistor NMos (N1) dont la source est connectée à la masse et dont le drain est connecté à la première borne de l'inductance ;
- un transistor PMos (P1) dont le drain est connecté à la première borne de l'inductance ;
- un dispositif de commande d'alimentation à découpage (2) générant des signaux de commande de commutation des transistors NMos et PMos aptes à ne pas rendre ces transistors passants simultanément;
**caractérisé en ce qu'**il comprend en outre :
- une capacité (C1) présentant une première borne connectée à la première borne de l'inductance (L) et une seconde borne ;
- une résistance (R1) présentant une première borne connectée à la seconde borne de la capacité (C1) et une seconde borne connectée à la masse ;
- un transistor NMos de détection (N2), dont la source est connectée à la masse, dont le drain est connecté à la grille du transistor PMos (P1) et dont la grille est connectée à la seconde borne de la capacité.

2. Source d'alimentation à découpage (3) selon la revendication 1, dans laquelle:
- la seconde borne de l'inductance (L) est connectée à une source d'alimentation à courant continu (Vbat) ;
- la source du transistor PMos (P1) est connectée au noeud de sortie (Vs).

3. Source d'alimentation à découpage (3) selon la revendication 2, comprenant en outre au moins un autre noeud de sortie et au moins un autre transistor PMos dont le drain est connecté à la première électrode de l'inductance (L), dont la source est connectée à l'autre noeud de sortie et dont la grille est connectée au drain du transistor NMos de détection (N2).

4. Source d'alimentation à découpage selon l'une quelconque des revendications précédentes,
- comprenant en outre un transistor de blocage (T1) présentant une première électrode connectée à la masse, une seconde électrode connectée à la grille du transistor NMos de détection (N2) et une électrode de commande ;
- le dispositif de commande d'alimentation à découpage rendant passant le transistor de blocage (T1) lorsque le transistor NMos (N2) de détection est passant.

5. Source d'alimentation à découpage (3) selon la revendication 4,
- comprenant en outre un transistor de commande (T2), présentant une première électrode connectée à la masse, une seconde électrode connectée à la grille du transistor PMos (P1) et une électrode de commande ;
- le dispositif de commande d'alimentation à découpage (2) commandant une conduction simultanée du transistor de commande (T2) et du transistor de blocage (T1).

6. Source d'alimentation à découpage (3) selon l'une quelconque des revendications précédentes, dans laquelle lesdits transistors, la capacité et la résistance sont intégrés sur un même substrat.

## Claims

1. Switching power supply source (3) comprising:
- an inductance (L) with first and second terminals;
- an output node (Vs);
- an NMos transistor (N1), the source of which is connected to the ground and the drain of which is connected to the first terminal of the inductance;
- a PMos transistor (P1), the drain of which is connected to the first terminal of the inductance;
- a switching power supply control device (2) generating switching control signals for NMos and PMos transistors capable of assuring that these transistors are not conducting simultaneously;
**characterized in that** it also comprises:
- a capacitor (C1) with a first terminal connected to the first terminal of the inductance (L) and a second terminal;
- a resistance (R1) with a first terminal connected to the second terminal of the capacitor (C1) and a second terminal connected to the ground;
- a detection NMos transistor (N2), the source of which is connected to the ground, the drain of which is connected to the grid of the PMos transistor (P1), and the grid of which is connected to the second terminal of the capacitor.

2. Switching power supply source (3) according to claim 1, in which:
- the second terminal of the inductance (L) is connected to a DC power supply source (Vbat);
- the source of the PMos transistor (P1) is connected to the output node (Vs).

3. Switching power supply source (3) according to claim 2, also comprising at least one other output node and at least one other PMos transistor, the drain of which is connected to the first electrode of the inductance (L), the source of which is connected to the other output node and the grid of which is connected to the drain of the detection NMos transistor (N2).

4. Switching power supply source according to any one of the previous claims,
- also comprising a blocking transistor (T1) with a first electrode connected to the ground, a second electrode connected to the grid of the detection NMos transistor (N2) and a control electrode;
- the switching power supply control device making the blocking transistor (T1) conducting when the detection NMos transistor (N2) is conducting.

5. Switching power supply source (3) according to claim 4,
- also comprising a control transistor (T2) with a first electrode connected to the ground, a second electrode connected to the grid of the PMos transistor (P1) and a control electrode;
- the switching power supply control device (2) controlling simultaneous conduction of the control transistor (T2) and the blocking transistor (T1).

6. Switching power supply source (3) according to any one of the previous claims, in which the said transistors, the capacitor and the resistance are integrated on the same substrate.

## Patentansprüche

1. Getaktete Stromversorgung (3), umfassend:
- eine Induktivität (L) mit einer ersten und einer zweiten Klemme;
- einen Ausgangsknoten (Vs);
- einen NMos-Transistor (N1), dessen Source-Anschluss mit der Masse verbunden ist und dessen Drain-Anschluss mit der ersten Klemme der Induktivität verbunden ist;
- einen PMos-Transistor (P1), dessen Drain-Anschluss mit der ersten Klemme der Induktivität verbunden ist;
- eine Steuervorrichtung (2) für das Schaltnetzteil, die Steuersignale für die Kommutation der NMos und PMos Transistoren erzeugt, die geeignet sind, diese Transistoren nicht gleichzeitig durchlässig zu machen;
**dadurch gekennzeichnet, dass** die getaktete Stromversorgung weiterhin umfasst:
- eine Kapazität (C1), die eine mit der ersten Klemme der Induktivität (L) verbundene erste Klemme und eine zweite Klemme aufweist;
- einen Widerstand (R1), der eine mit der zweiten Klemme der Kapazität (C1) verbundene erste Klemme und eine mit der Masse verbundene zweite Klemme aufweist;
- einen Detektions-NMos-Transistor (N2), dessen Source-Anschluss mit der Masse verbunden ist, dessen Drain-Anschluss mit dem Gitter des PMos Transistors (P1) verbunden ist, und dessen Gitter mit der zweiten Klemme der Kapzität verbunden ist.

2. Getaktete Stromversorgung (3) gemäß Anspruch 1, wobei:
- die zweite Klemme der Induktivität (L) mit einer Gleichstromquelle (Vbat) verbunden ist und
- der Source-Anschluss des PMos Transistors (P1) mit dem Ausgangsknoten (Vs) verbunden ist.

3. Getaktete Stromversorgung (3) nach Anspruch 3, ferner umfassend zumindest einen weiteren Ausgangsknoten und einen weiteren PMos Transistor, dessen Drain-Anschluss mit der ersten Elektrode der Induktivität (L) und dessen Source-Anschluss mit dem weiteren Ausgangsknoten verbunden ist, und dessen Gitter mit dem Drain-Anschluss des Detektions-NMos-Transistors (N2) verbunden ist.

4. Getaktete Stromversorgung nach einem der vorhergehenden Ansprüche, ferner umfassend
- einen Sperrtransistor (T1) mit einer ersten Elektrode, die mit der Masse verbunden ist, mit einer zweiten Elektrode, die mit dem Gitter des Detektions-NMos-Transistors (N2) verbunden ist, und mit einer Steuerelektrode;
- wobei die Steuervorrichtung des Schaltnetzteils den Sperrtransistor (T1) durchlässig macht, wenn der Detektions-NMos-Transistor (N2) durchlässig ist.

5. Getaktete Stromversorgung (3) nach Anspruch 4, ferner umfassend:
- einen Steuertransistor (T2) mit einer ersten Elektrode, die mit der Masse verbunden ist, mit einer zweiten Elektrode, die mit dem Gitter des PMos Transistors (P1) verbunden ist, und mit einer Steuerelektrode;
- wobei die Steuervorrichtung (2) des Schaltnetzteils eine simultane Leitung des Steuerstransistors (T2) und des Sperrtransistors (T1) steuert.

6. Getaktete Stromversorgung (3) nach einem der vorhergehenden Ansprüche, wobei die Transistoren, die Kapazität und der Widerstand in dasselbe Substrat integriert sind.
